Europäisches Patentamt

European Patent Office

Office européen des brevets

(19)

(11) Publication number: 0 044 519

A1

# (12) EUROPEAN PATENT APPLICATION

(21) Application number: 81105542.5

(22) Date of filing: 15.07.81

(51) Int. Cl.³: H 05 K 13/04

(30) Priority: 22.07.80 IT 2359280

(43) Date of publication of application:
27.01.82 Bulletin 82/4

(84) Designated Contracting States:
AT CH DE FR GB IT LI NL SE

(71) Applicant: FERCO S.p.A.
Via della Pusteria, 29
I-20020 Misinto (Milan)(IT)

(72) Inventor: Ferri, Beniamino
Via Rovani 6
20052 Monza Milan(IT)

(72) Inventor: Caimi, Giovanni
Via Volta 101
21047 Saronno Varese(IT)

(74) Representative: Borella, Ada
Ing. A. Racheli & C. Viale San Michele del Carso, 4
I-20144 Milan(IT)

(54) A process and apparatus for assembling electric microcomponents on printed circuit boards.

(57) This invention provides a process and relating apparatus comprising at least one unit for gripping at least one microcomponent (41a, 41b, 41c) arranged at the top opening (55) of a magazine (52) containing the stacked microcomponents, then supplying the microcomponent to a preselected position of a printed circuit board (20). Each of the units comprises at least one gripping means (43, 44) for selectively withdrawing and supplying a single microcomponent (41a, 41b, 41c); a control member (49) for opening and closing said gripping means, a handling means for moving said gripping means (43, 44) from a position substantially corresponding to the top opening (52) of the stack of microcomponents to another position substantially corresponding to the application position for said microcomponent (41a, 41b, 41c) on said printed circuit board (20) and a means for feeding each of the microcomponent inside the magazine by an amount corresponding to the thickness of the component therein retained.

./...

Croydon Printing Company Ltd.

EP 0 044 519 A1

FIG.1

Applicant:

FERCO S.p.A.

I - 20020 - MISINTO (Milan)

Via della Pusteria, 29

"A PROCESS AND APPARATUS FOR ASSEMBLING ELECTRIC MICROCOMPONENTS
ON PRINTED CIRCUIT BOARDS".

This invention relates to a process and relating apparatus for assembling electric microcomponents, for example the so-called "chip" type elements, which, as well known, are formed of nearly parallelopiped plates having the two minor bases thereof covered with a metal coating enabling the welding thereof on a printed circuit board. By suitable modifications to be made to the pliers, the apparatus can be used to assemble cylindrical microcomponents, such as MELF components and active microcomponents provided at some places with pins, such as SOT components.

As well known, these electric components are extremely small and accordingly enable to conveniently provide circuits of extremely reduced dimensions. However, this inherent smallness thereof makes their handling highly complicated and costly. Thus in the manufacture of even small series, such components would require an automatic assembling by means of machines on the respective printed circuit boards.

Attempts have already been made to provide a machine for presetting the required microcomponents at the desired locations, on a printed circuit board. According jo this approach, the microcomponents contained in magazines as parallel stacks are vacuum withdrawn by a perforated flat withdrawing plate, in which the holes are connected to a vacuum source, said plate moving along a determined path, so as to deposit the withdrawn components on the printed circuit as soon as the vacuum has been released. However, this process suffers from the disadvantage that at a single withdrawal position of the withdrawing plate more than one microcomponent may often remain attached to said plate, thus providing faulty circuits.

It is a limitation of the apparatus at present used that the vacuum withdrawing plate should come in contact with the printed circuit board, so as to preclude the use of partly occupied boards comprising, for example, electric elements previously assembled thereon.

It is another disadvantage of the known approach that only microcomponents having the same thickness can be simultaneously applied, since all of these microcomponents should come in contact with the printed circuit board.

Therefore, it is the object of the present invention to provide a process aõd relating apparatus for assembling microcomponents on printed circuit boards, providing unexceptionable circuits at reduced costs.

It is a further object of the invention also to enable the use of printed circuit boards having a considerable overall size in thickness due to electric elements that have been previously assembled thereon.

It is still another object of the invention to enable the simultaneous assembling of microcomponents having different thicknesses.

The possibility is also provided of compensating the tolerances in thickness of each individual microcomponents.

It is another object of the invention to allow the use of microcomponents even not correctly centered inside the magazines.

Finally, it is another object of the present invention to allow, between the microcomponent gripping and supplying steps, the control of the presence of the desired microcomponents and/or also an electric check thereof.

The above mentioned objects have been accomplished by providing the following operating cycle:

(a) at rest condition, one or each of the gripping means are arranged adjacent to the top opening of each microcomponent magazine;

(b) one or each of gripping means close by gripping the microcomponent arranged immediately near the top opening of each magazine;

(c) the or each of the gripping means are driven by handling means, while holding the previously gripped component, moving to face the application position of said microcomponent on the printed circuit board;

(d) the or each of the gripping means open releasing the respective microcomponent on the printed circuit board which before had been provided with glue at the preselected application positions;

(e) the or each of the gripping means move back to the originary position substantially adjacent to the top opening of each microcomponent magazine; and

(f) the microcomponent stacks are feeded by an amount corresponding to the thickness of the respective component in each stack.

A particular embodiment of the invention provides that the transfer unit handling start occurs in the plane containing the free top opening of the microcomponent stacks, so as to ensure the separation of the withdrawn component from the lower adjacent component.

A variant to the above described process provides that during or at the end step (c) for the gripping means, a visual and/or electric check of the microcomponents just withdrawn is carried on. In this latter case, it will be provided that the gripping means are at least partially insulated.

The relative apparatus for carrying out the above specified process comprises a unit, which will be hereinafter referred to as a "transfer" unit, for gripping and supplying at least one microcomponent to a preselected position on a printed circuit board, each of the units comprising at least one gripping means for selectively gripping and releasing a microcomponent; a handling means for moving said unit from a position substantially corresponding to the top opening of the microcomponent stacks to another position substantially corresponding to the application position for said microcomponent or microcomponents on said printed circuit board; and a means for feeding said microcomponent or microcomponents along the stacks inside the magazines, so as to allow the gradual withdrawal thereof.

An approach of the invention provides that each of the gripping means comprise a pliers having resilient legs sliding within a guide forming the control member for opening and closing each of the gripping means, such a guide cooperating with the conjugated surfaces of said pliers legs, so that the movement of said guide varies the position of said resilient legs, thus selectively providing for gripping and supplying the relative component.

A particular approach of the invention provides that the pliers are formed of four resilient legs coming in contact with the four sides of minor surface of the parallelopiped forming the microcomponent, thereby centering the latter.

An embodiment of the invention further provides that the gripping end of the pliers is formed to receive the respective component therein, adaptable to the size of the latter, particularly to the thickness thereof.

Provision is also made for compensating the thickness tolerances by means of friction sliding assembling of the pliers within the support thereof.

The invention will now be further explained with reference to an exemplary embodiment which has been schematically shown at the successive operating steps on the accompanying drawings, in which:

Figs. 1, 2, 2a, 3, 3a and 4 are all sectional views taken along line 1-1 of Fig. 5, showing an embodiment according to the invention at different operating steps;

Figs. 5 and 6 are views at the gripping side, particularly sectional views taken along lines 5-5 and 6-6, respecjively of Figs. 7 and 8, at two different operating positions;

Figs. 7 and 8 are sectional views taken along lines 1-1 and 8-8, respectively, of Fig. 5 and 6;

Fig. 9 is a plan view showing another embodiment of the gripping means; and

Figs. 10 and 11 are sectional views taken along lines 10-10 and 11-11, respectively, of Fig. 9, showing the end portions of the gripping means.

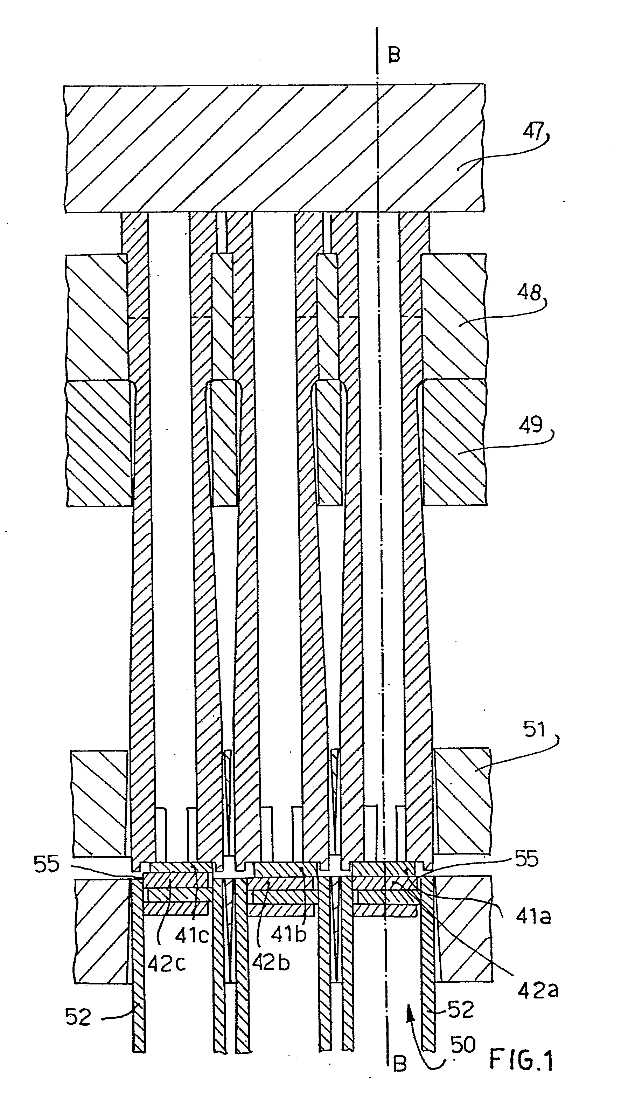

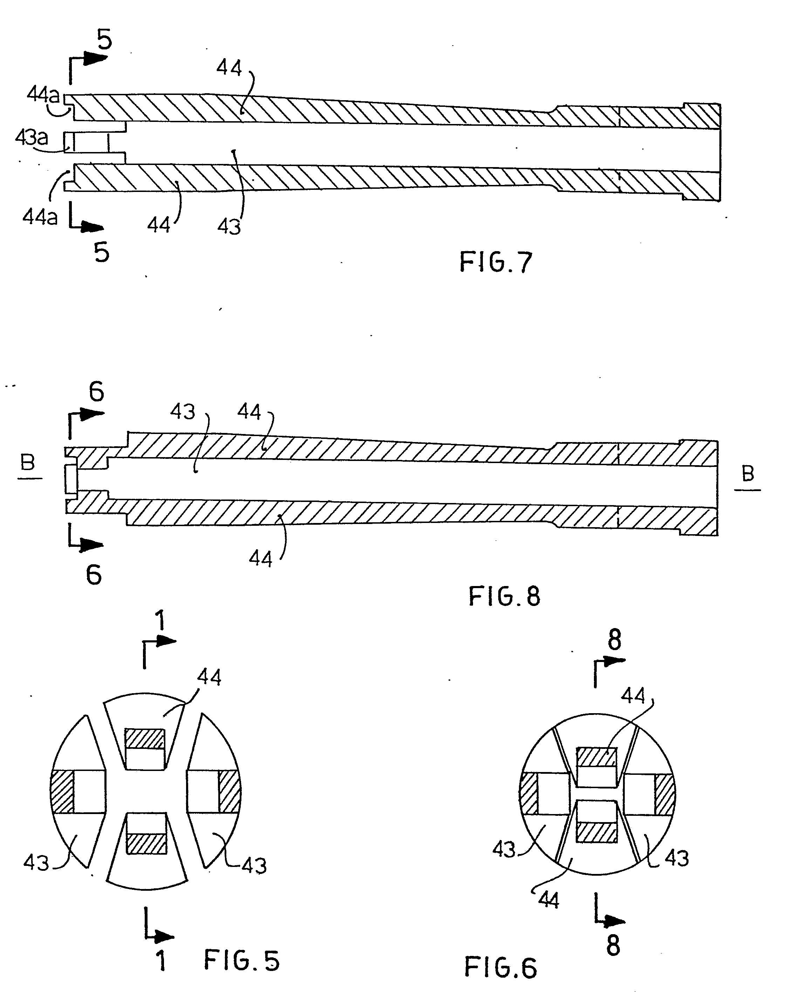

Referring to the figures of the accompanying drawings, an embodiment according to the invention will now be described, in which the gripping means comprise pliers having four legs facing one another in pairs and each pair being perpendicular to the other. The microcomponents that have been shown in this embodiment are contained in magazines 52, so as to form stacks of microcomponents generally having reference numeral 50. In the respective figures of the drawings, some microcomponents have been designated by reference numeral 41a, 41b, 41c and 42a, 42b and 42c. As it will be seen, the different microcomponents have different thicknesses, different thickness tolerances and also different positions in the respective magazines 52. The gripping means shown in Figs. 5 and 6 are adapted to clamp microcomponents having no pins. Such means comprise four legs forming two pairs 43 and 44, which at the gripping end are configurated to provide cavities 43a and 44a, which cavities as a whole can receive the respective microcomponent 41a, 41b and 41c, as shown in Figs. 1 to 4. These cavities can be adapted to exactly receive the microcomponent therein, and at the same time to form a stop abutment for the stack 50 of the respective microcomponents.

Where the microcomponents have at least one side provided with pins, other configurations could be provided for the pliers gripping said microcomponents, having tips which do not damage the contacts formed by the pins.

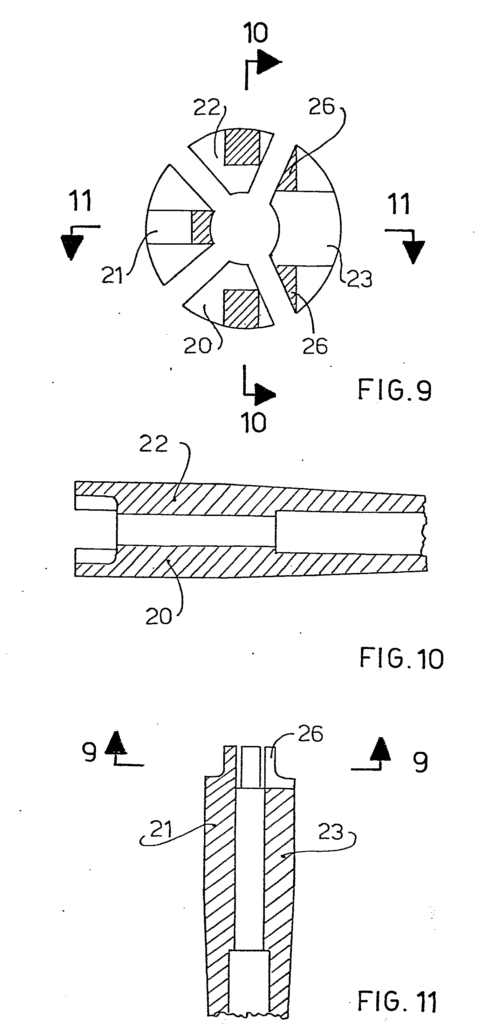

Another embodiment of the gripping means is shown in Figs. 9, 10 and 11, showing a pliers provided with four legs 20, 21, 22 and 23 for clamping the component where the pins have not been provided. In this embodiment, legs 20, 21 and 22 would normally clamp the component, whereas leg 23 contacts the ends of the side of the microcomponent provided with pins only by tips 26.

However the pliers comprising the gripping means are made, such pliers are contained within a transfer unit, of which only three pliers units are shown in the sectional views of Figs. 1 to 4. This unit can move as a whole by means of a handling means, not shown.

The operation of the pliers legs for gripping and supplying a component takes place through the movement of plates moving along the axis B-B of said pliers, and cooperating with conical surfaces on the pliers legs. Of course, the plates could as well be conical too.

In Figs. 1 to 4, the zero setting plate 47 is shown which will serve, as hereinafter discussed in connection with positioning operation, after the microcomponent thickness tolerances have been compensated, the pliers supporting plate 48, the pliers operating plate 49 and the guide plate 51. The mutual movements of these plates to grip and then supply the components are as follows:

Fig. 1 shows how the pliers operating plate 49 is caused to adhere to the supporting plate 48, so that said operating plate 49 is located at the narrowest portion of the pliers legs to allow the opening thereof. The pliers supporting plate 48 is arranged so that the pliers ends forming a housing for the component 41a, 41b and 41c are arranged at the free top opening 55 of the magazines 52. As above mentioned, this housing for the components 41a, 41b and 41c is formed by the cavity assembly 43a and 44a.

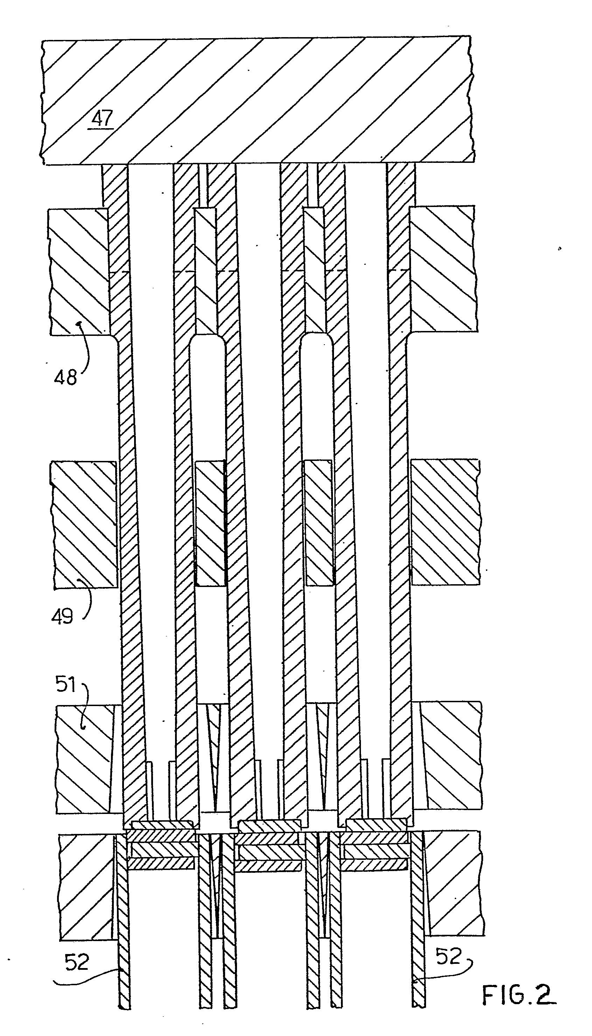

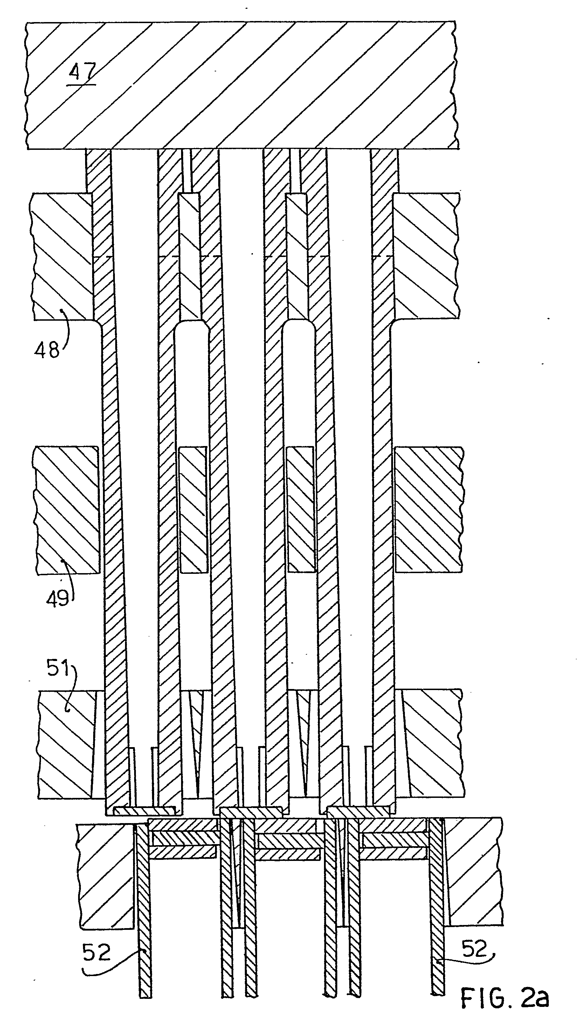

5. Fig. 2 is a view showing the second step of the process, in which the pliers have now gripped the respective component: this has been achieved by sliding the operating plate 49 towards the thickest zone of the pliers, so that the latter close.

Now, the handling unit connected to said plates 47, 48, 49 and 51 preferably travels a short distance parallel to the plane of the free top openings 55 of the magazines 52, to positively separate the microcomponents 41a, 41b and 41c from the underlying components 42a, 42b and 42c. This has been shown in Fig. 2a.

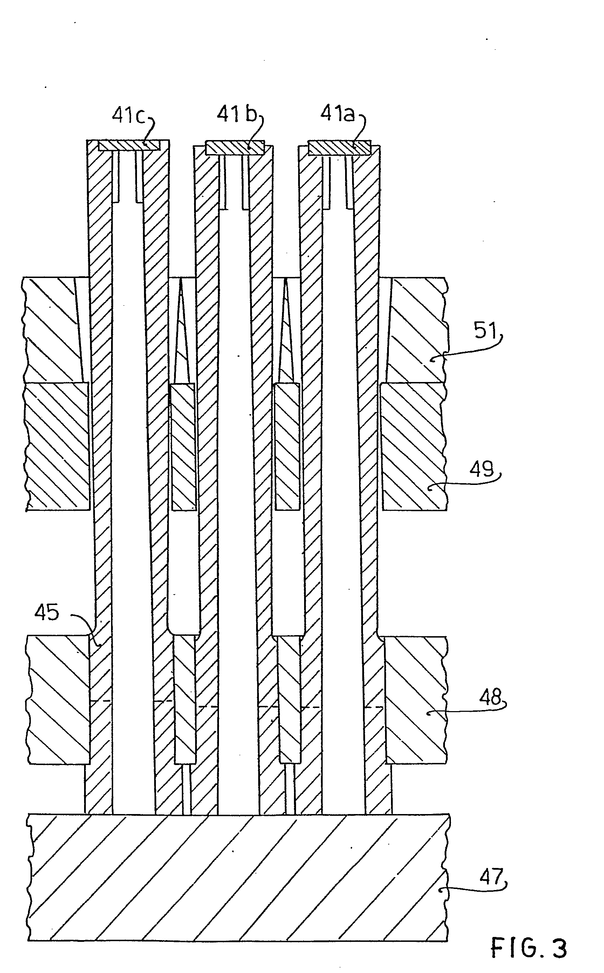

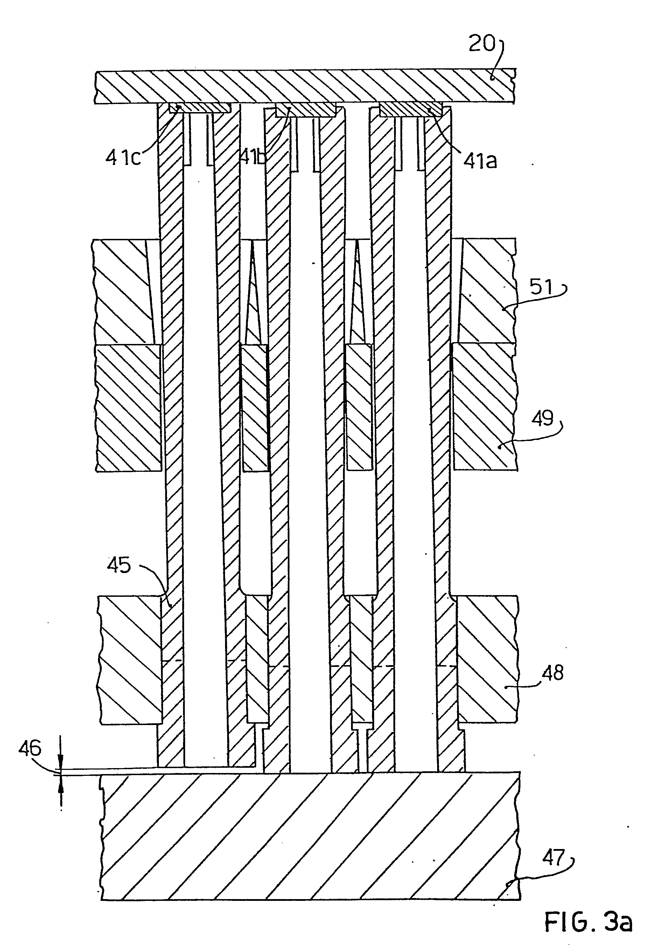

The transfer unit now moves again, for example, provides an upward rotation of jhe pliers which still hold the relative component 41a, 41b and 41c. At this step shown in Fig. 3, a visual and/or electric check of the respective components can be made, assuming that the pliers are at least partially insulated.

The further sjep of the process of Fig. 3a shows that the transfer unit has continued its travel to reach the priõted circuit board 20, or the board 20 has been moved toward the pliers.

So far the pliers have always remained at gripping condition and hold therebetween the respective microcomponent that had been previously gripped. The guide plate 51 has moved away from the pliers end to free the largest space possible. This is to allow any possible former prearrangement of conventional components on the printed circuit boards. Therefore, the board may not be perfectly flat.

In the meanwhile, as all of the external surfaces of the components 41a, 41b and 41c adhere on board 20, it may occur that such surfaces would not perfectly adhere due to the different tolerances in the component thicknesses. Thus Fig. 3a show that the first pliers at the left, which has gripped the component 41c of reduced tolerance, did not move relative to the supporting plates 48, while the other two pliers, namely the central and right pliers that have gripped the components 41b and 41a are retracted relative to the supporting plate 48 by the amount 46, thus causing the retraction also of the zero setting plate 47. Thus a sliding assembling of body 45 of each pliers within the supporting plate 48 is provided.

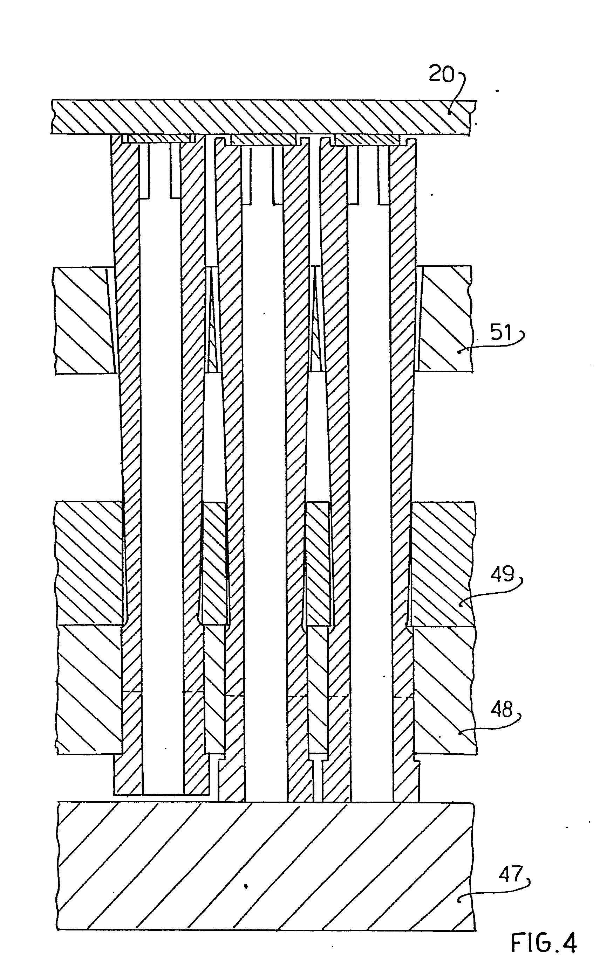

Fig. 4 shows the step where the component is positioned on the printed circuit board 20. This is achieved by simple moving the operating plate 49 back to the narrowest zone of the pliers, that is in proximity of the plate 48 which supports the pliers.

This step will be merely followed by the return of the pliers supporting plate 48 to the original position at the top openings 55 of the magazines 52 and this of course along with the pliers and plates 47, 49 and 51. At the same time, the zero setting plate 47 will be moved towards the supporting plate 48 to reset all the displacements 46 due to the component thickness tolerances and thus the apparatus will be ready to receive another set of components. Immediately before, simultaneously with or just after the positioning of the pliers at the top openings 55 of the magazines, the feeding of the component stacks will be provided, so that the components 42a, 42b and 42c underlying the components 41a, 41b and 41c, which have just been withdrawn during the preceding cycle, are arranged within the housing provided by the series of pliers cavities 43a and 44a.

The above described gripping means may be implemented as joined series to provide for gripping and supplying all of the required microcomponents for a determined printed circuit board.

This invention embraces all the detail modifications which may be obvious to those skilled in the art.

FERCO S.p.A.
20020 MISINTO (Milan) Italy

C L A I M S

1.        A process for applying microcomponents on printed circuit boards, according to which said components are withdrawn from a series of magazines arranged side by side and in parallel relationship to one another and caused to adhere to a printed circuit board previously provided with glue, characterized in that:

(a) at rest condition each gripping means (43, 44) is arranged at the top opening (55) of each of the microcomponent magazines (52);

(b) each gripping means (43, 44) closes gripping the microcomponent (41a, 41b, 41c) arranged at the top opening (55) of the magazines (52);

(c) each gripping means (43, 44) is moved while holding therebetween the microcomponent (41a, 41b, 41c) previously gripped;

(d) each gripping means (43, 44) contacts the printed circuit board (20) on which, as known, the glue had been previously applied;

(e) each gripping means (43, 44) opens, leaving the microcomponent (41a, 41b, 41c) on the printed circuit board (20);

(f) each gripping means (43, 44) moves back to the original position substantially adjacent to the top openings (55) of the microcomponent magazines (52); and

(g) each component stacks is fed by an amount corresponding to the thickness of the relative component.

2. A process according to Claim 1, characterized in that the gripping means (43, 44) after gripping the relative microcomponent (41a, 41b, 41c) travels in the plane of the free top openings (55) for positively separating the withdrawn component (41a, 41b, 41c) from the adjacent microcomponent (42a, 42b, 42c).

3. A process according to Claim 1 or Claim 2, characterized in that during the step according to which each gripping means (43, 44), is moved and before the latter contacts the printed circuit board (20), a step is provided for visually and/or electrically controlling the microcomponents (41a, 41b, 41c) that have been gripped by the gripping means (43, 44).

4. An apparatus for carrying out the process according to any of the Claims 1 to 3, the apparatus including a transfer unit comprising a series of gripping means (43, 44) for a set of microcomponents (41a, 41b, 41c) arranged at the top openings (55) of stacks (50) forming parallel magazines and supplying the latter to predetermined positions of a printed circuit board, characterized in that each of the gripping means for gripping a microcomponent (41a, 41b, 41c) comprises a pliers (43, 44) selectively operable for gripping and releasing said component.

5.      An apparatus according to Claim 4, characterized in that the transfer unit initially moves in the plane comprising the free top openings (55) of the magazines (52).

6.      An apparatus according to Claim 4 or Claim 5, characterized in that the step during which the transfer unit is moved provides an intermediate dwell before contacting the printed circuit board (20), so as to allow possible controls on the microcomponents (41a, 41b, 41c) just withdrawn.

7.      An apparatus according to Claim 6, characterized in that the pliers are at least partially insulated, so that electric controls on the components (41a, 41b, 41c) are also allowed.

8.      An apparatus according to any of Claims 4 to 7, characterized in that the pliers (43, 44) are provided with a housing (43a, 44a) for receiving the respective microcomponent (41a, 41b, 41c).

9.      An apparatus according to any of Claims 4 to A, characterized in that a slide drive fit is provided for the pliers within the supporting plate (48), so that on adhering the component (41a, 41b, 41c) to the printed circuit board (20) any possible difference in thickness of said components is compensated by a displacement of the pliers (43, 44) relative to the supporting plate (48), a zero setting plate (47) being also provided which will reset all of the pliers (43, 44) at the beginning of each cycle.

10.     An apparatus according to any of Claims 4 to 9, characterized in that during the application of the microcomponents (41a, 41b, 41c), the pliers are caused to move out of the transfer plate boundary, for example by merely retracting a guide plate (51), so as to enable the application of microcomponents (41a, 41b, 41c) even on printed circuit boards (20) having a considerable thickness.

FIG.1

FIG.2

FIG. 2a

0044519

41c  41b  41a

51

49

45

48

47

FIG.3

0044519

FIG. 3a

FIG.4

FIG.7

FIG.8

FIG.5

FIG.6

FIG.9

FIG.10

FIG. 11

**European Patent Office**

**EUROPEAN SEARCH REPORT**

Application number

EP 81 10 5542

| Category | Citation of document with indication, where appropriate, of relevant passages | Relevant to claim |
|---|---|---|
| A | US - A - 4 099 324 (MOTOROLA INC.)<br><br>* claims; figure 5 *<br><br>-- | 1 |
| A | DE - A - 2 716 330 (MATSUSHITA ELECTRIC INDUSTRIAL CO.)<br><br>* claims; figures 1-12 * | 1 |

**CLASSIFICATION OF THE APPLICATION (Int. Cl.3)**

H 05 K 13/04

**TECHNICAL FIELDS SEARCHED (Int. Cl.3)**

H 05 K 13/04
13/02
3/30
H 01 L 21/68

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 1-10-1981 | VAN REETH |

EPO Form 1503.1   06.78